Europäisches Patentamt

European Patent Office

Office européen des brevets

(19)

(11) Veröffentlichungsnummer: **0 218 058**
**B1**

(12) **EUROPÄISCHE PATENTSCHRIFT**

(45) Veröffentlichungstag der Patentschrift: 09.05.90

(21) Anmeldenummer: **86111443.7**

(22) Anmeldetag: **19.08.86**

(51) Int. Cl.⁵: **G 01 R 1/073,** G 01 R 31/28

(54) **Vorrichtung für die elektrische Funktionsprüfung von Verdrahtungsfeldern, insbesondere von Leiterplatten.**

(30) Priorität: 04.09.85 DE 3531604

(43) Veröffentlichungstag der Anmeldung:
15.04.87 Patentblatt 87/16

(45) Bekanntmachung des Hinweises auf die
Patenterteilung:
09.05.90 Patentblatt 90/19

(84) Benannte Vertragsstaaten:
AT BE CH DE FR GB IT LI NL SE

(56) Entgegenhaltungen:
EP-A-0 102 565
EP-A-0 107 771

IBM TECHNICAL DISCLOSURE BULLETIN, Band
14, Nr. 5, Oktober 1971, Seite 1601, New York,
US; H. BOHLEN et al.: "Tester for electric
conductors"

(73) Patentinhaber: Siemens Aktiengesellschaft
Wittelsbacherplatz 2
D-8000 München 2 (DE)

(72) Erfinder: Doemens, Günter, Dr.
Föchingerstrasse 4
D-8150 Holzkirchen (DE)
Erfinder: Glieden, Manfred, Dipl.-Phys.
Preetoriusweg 3/1
D-8000 München 83 (DE)

EP 0 218 058 B1

**Beschreibung**

Die Erfindung betrifft eine Vorrichtung für die elektrische Funktionsprüfung von Verdrahtungsfeldern, insbesondere von Leiterplatten, nach dem Oberbegriff des Anspruchs 1.

In Prüfautomaten und Prüfadaptern für unbestückte und bestückte Leiterplatten sowie für Verdrahtungsfelder in Löt- oder Crimptechnik wird die Kontaktierung der ausgewählten Meßstellen in der Regel über federnde Prüfspitzen vorgengommen. Die entsprechend dem Rastermaß eines zu prüfenden Verdrahtungsfeldes angeordneten federnden Prüfspitzen werden mittels Federhülsen befestigt, die in eine Trägerplatte eingepreßt sind und in die man die Prüfspitzen einschiebt. Bei der Auswahl der Prüfspitzen entscheiden üblicherweise der kleinste Abstand der Meßstellen zueinander sowie die Strombelastung über den Durchmesser der federnden Prüfspitzen, wobei als unteres Grenzmaß für den Durchmesser jedoch 0,69 mm genannt werden (Elektronik Produktion & Prüftechnik, November 1979, Seiten 472 und 473).

Mit den bekannten Vorrichtungen für die elektrische Funktionsprüfung von Leiterplatten werden zwischen den durch Rasterpunkte entsprechend dem Layout gebildeten Prüfstellen Leitfähigkeits- und Isolationsmessungen durchgeführt. Da die für die Ankontaktierung der Prüfstellen vorgesehenen federnden Prüfspitzen im Raster der Leiterplatte angeordnet werden müssen, stößt die Realisierung derartiger Vorrichtungen bei abnehmendem Rastermaß und größer werdenden Flächen der Leiterplatten zunehmend auf prinzipielle Schwierigkeiten. So ist eine Anordnung der federnden Prüfspitzen in Rastermaßen unter einem Millimeter bei einer sicheren mechanischen Kontaktierung der Prüfstellen feinwerktechnisch kaum mehr beherrschbar. Mit der Anzahl der Meßstellen, die beispielsweise Hunderttausend betragen kann, steigt auch die Anzahl der erforderlichen Zuleitungen und Schaltelemente, wodurch ein erheblicher gerätetechnischer Aufwand und entsprechend hohe Kosten verursacht werden. Außerdem nimmt mit der Anzahl der Meßstellen auch die Wahrscheinlichkeit einer vollständigen Kontaktierung der Leiterplatten erheblich ab.

Der nächstliegende Stand der Technik, wie er im Oberbegriff des Anspruches 1 wiedergegeben ist, ist aus der EP-A-0 102 565 bekannt, die eine Vorrichtung für die elektrische Funktionsprüfung von Verdrahtungsfeldern beschreibt, bei welcher die bisher übliche ohm'sche Kontaktierung der Meßstellen durch eine berührungslose ionische Kontaktierung über Gasentladungsstrecken ersetzt wird. Hierzu wird in eine auf die Verdrahtungsfelder aufsetzbare Trägerplatte eine Vielzahl von mit Elektroden versehenen Gasentladungskanälen eingebracht, wobei die im Raster der Verdrahtungsfelder angeordneten Gasentladungskanäle zu den Meßstellen hin offen sind. Sind nun zwei ausgewählte Meßstellen beispielsweise durch eine Leiterbahn elektrisch leitend miteinander verbunden, so bilden die zugeordneten Gasentladungskanäle zwei in Reihe geschaltete Gasentladungsstrecken, die durch Anlegen einer hinreichend hohen Spannung an die Elektroden gezündet werden können. Mit der Zündung der Gasentladungen erfolgt dann ein Stromtransport, der zu Prüfzwecken ausgewertet werden kann. Unterbleibt die Zündung der Gasentladungen oder fließt nach einer Zündung ein zu geringer Strom, so kann auf eine unterbrochene oder von vorneherein nicht existierende elektrisch leitende Verbindung zwischen den ausgewählten Meßstellen geschlossen werden. Wird der an die Elektroden angelegten Spannung eine Wechselspannung überlagert, so kann die daraus resultierende Stromänderung phasenempfindlich zur angelegten Wechselspannung gemessen und für die Bestimmung des Widerstandes einer zwischen den ausgewählten Meßstellen bestehenden Verbindung herangezogen werden. Die bekannte Vorrichtung ermöglicht also Leitfähigkeits- und Isolationsmessungen, wobei durch das Vermeiden von ohm'schen Kontakten eine sehr hohe Zuverlässigkeit erreicht wird. Durch das Prinzip der ionischen Kontaktierung der Meßstellen über in äußerst geringen Abmessungen realisierbare Gasentladungskanäle können dann insbesondere auch Verdrahtungsfelder mit kleinen Rastermaßen der Meßstellen bis herab zu 0,1 mm zuverlässig geprüft werden. Bei einer hohen Anzahl der Meßstellen eines zu prüfenden Verdrahtungsfeldes treten jedoch nach wie vor Probleme auf, die durch die zahlreichen Zuleitungen und Schaltelemente für den Anschluß der Elektroden der Gasentladungskanäle zurückzuführen sind.

Der Erfindung liegt die Aufgabe zugrunde, bei einer Vorrichtung der eingangs genannten Art die Anzahl der Zuleitungen drastisch zu reduzieren.

Diese Aufgabe wird erfindungsgemäß durch die kennzeichnenden Merkmale des Anspruchs 1 gelöst.

Der Erfindung liegt die Erkenntnis zugrunde, daß jeder Gasentladungskanal mit mindestens zwei Elektroden bestückt werden kann, wobei die Ansteuerung einer Elektrode allein noch kein Zünden und Brennen von Gasentladungen hervorruft, die Ansteuerung sämtlicher Elektroden jedoch für ein sicheres Zünden und Brennen von Gasentladungen ausreicht. Durch eine derartige Auswahl und Ansteuerung der Gasentladungskanäle nach dem Koinzidenzprinzip werden die Voraussetzungen für eine Matrixadressierung der Meßstellen geschaffen, die mit der Adressierung der einzelnen Kerne eines Kernspeichers vergleichbar ist. Dementsprechend kann dann auch die Auswahl der den Meßstellen zugeordneten Gasentladungskanäle über entsprechende Elektroden-Sammelleitungen vorgenommen werden, wodurch gegenüber der direkten Ansteuerung eines jeden Gasentladungskanals der für die Ansteuerung erforderliche Aufwand ganz erheblich reduziert werden kann.

Die Auswahl eines mit vorzugsweise zwei Elektroden ausgerüsteten Gasentladungskanals nach dem Koinzidenzprinzip über zwei Elektroden-Sammelleitungen kann grundsätzlich darauf beruhen, daß das Zünden und/oder Brennen einer Gasentladung erst durch das Zusammenwirken beider Elektroden ermöglicht wird oder daß das Zünden und/oder Brennen einer Gasentladung durch eine der Elektroden verhindert wird, wobei diese Hemmwirkung durch eine Ansteuerung dieser Elektrode aufgehoben wird.

Bei der erfindungsgemäßen Vorrichung für die elektrische Funktionsprüfung von Verdrahtungsfeldern werden die Meßstellen ionisch kontaktiert, d.h. eine Elektrode der Gasentladungsstrecken wird unmittelbar durch die Meßstellen auf der Leiterplatte gebildet. Durch das Vermeiden von ohm'schen Kontakten wird dabei eine sehr hohe Zuverlässigkeit erreicht. Die Vorteile der erfindungsgemäßen Adressierung, insbesondere Matrixadressierung von Meßstellen bzw. Gasentladungskanälen mit einer erheblichen Reduzierung des Verdrahtungsaufwands ergeben sich jedoch auch dann, wenn eine ohm'sche Kontaktierung der Meßstellen durch am unteren Ende der Gasentladungskanäle angeordnete federnde Prüfspitzen vorgenommen wird. Diese federnden Prüfspitzen bilden dann eine weitere Elektrode der Gasentladungskanäle, d.h. sie werden an dem der Spitze gegenüberliegenden Ende ionisch kontaktiert und können mit geringeren Durchmessern realisiert werden als die mit einer Verdrahtung verbundenen herkömmlichen Prüfspitzen. Die geringen Rasterabmessungen bei einer ionischen Kontaktierung mit zu den Meßstellen hin offenen Gasentladungskanälen können mit Prüfspitzen jedoch nicht erreicht werden.

Gemäß einer bevorzugten Ausgestaltung der Erfindung ist vorgesehen, daß erste Elektroden der Gasentladungskanäle reihenweise über erste Elektroden-Sammelleitungen miteinander verbunden sind und daß zweite Elektroden der Gasentladungskanäle reihenweise über zweite Elektroden-Sammelleitungen miteinander verbunden sind. Bei einer derartigen Ausbildung, die insbesondere für Leiterplatten mit einer Anordnung der Meßstellen in einem regelmäßigen Raster geeignet ist, ergibt sich eine besonders einfache und übersichtliche Verlegung der Elektroden-Sammelleitungen. Außerdem entspricht die reihenweise Zusammenfassung der Elektroden dem Idealfall einer Matrixadressierung der Meßstellen.

Weiterhin ist es besonders vorteilhaft, wenn die ersten und die zweiten Elektroden in verschiedenen Höhenlagen der Gasentladungskanäle angeordnet sind. Eine der Elektroden kann dann die Aufgabe eines Gitters übernehmen, mit welchem die Zündung einer Gasentladung besonders zuverlässig gesteuert, d.h. verhindert oder eingeleitet werden kann.

Es ist aber auch möglich, die zweiten Elektroden mit einem elektrisch isolierenden Material zu umhüllen. Diese zweiten Elektroden können dann mit Spannungsimpulsen beschickt werden, welche als Zündimpulse die Zündung von Gasentladungen bewirken. Im übrigen üben derartige mit einer Isolierung versehene Elektroden keinen merklichen Einfluß auf die Gasentladungsstrecken aus.

Eine weitere Reduzierung des Verdrahtungsaufwands ergibt sich, wenn die Elektroden durch die Gasentladungskanäle überquerende Abschnitte der Elektroden-Sammelleitungen gebildet sind.

Es ist auch besonders günstig, wenn die ersten Elektroden-Sammelleitungen und die zweiten Elektroden-Sammelleitungen sich kreuzend angeordnet sind, wobei sie sich vorzugsweise unter einem Winkel von 45° kreuzen. Durch diese Maßnahme wird dem Umstand Rechnung getragen, daß zwei ausgewählte Meßstellen nicht über eine gemeinsame Elektroden-Sammelleitung adressiert werden können. Bei einer sich kreuzenden Anordnung der Elektroden-Sammelleitung können dann durch eine Verdrehung der gesamten Trägerplatte um einen Winkel von 90° oder 270° relativ zur Verdrahtung sämtliche Meßstellen sicher erfaßt werden.

Ist der Abstand zwischen der ersten Elektrode und der zweiten Elektrode eines Gasentladungskanals klein im Verhältnis zum Abstand zwischen der zweiten Elektrode und einer zugeordneten Meßstelle, so wird die Sicherheit und Zuverlässigkeit der Vorrichtung weiter erhöht. Bei einem geringen Abstand zwischen der ersten und der zweiten Elektrode findet keine Ionisierung statt oder es entstehen so wenig Ionen, daß eine unerwünschte Gasentladung zwischen der ersten und zweiten Elektrode nicht zünden kann. Im Hinblick darauf hat es sich als besonders günstig erwiesen, wenn das Verhältnis des Abstandes zwischen der ersten Elektrode und der zweiten Elektrode zum Abstand zwischen der zweiten Elektrode und der zugeordneten Meßstelle mindestens 1 : 10 beträgt.

Ist zwischen der ersten Elektrode und der zweiten Elektrode eines Gasentladungskanals ein elektrischer Isolator angeordnet, so wird die Wahrscheinlichkeit der Zündung einer Gasentladung zwischen beiden Elektroden weiter herabgesetzt. Außerdem kann dann der Abstand zwischen beiden Elektroden besonders gering bemessen werden.

Sind die Elektroden-Sammelleitungen bandförmig ausgebildet, so kann ihre Herstellung und Verlegung mit auf dem Gebiet der Schaltungstechnik bewährten Methoden weiter vereinfacht werden. Insbesondere können dann die Elektroden-Sammelleitungen durch die Leiterbahnen einer Schichtschaltung gebildet werden.

Eine besonders hohe Funktionssicherheit wird erreicht, wenn an die ersten Elektroden zweier ausgewählter Gasentladungskanäle über die zugeordneten ersten Elektroden-Sammelleitungen eine Spannung anlegbar ist, welche zumindest der doppelten Zündspannung einer Gasentladungsstrecke entspricht und wenn an die zweiten Elektroden der beiden Gasentladungskanäle über die zugeordneten zweiten Elektroden-Sammelleitungen eine derartige Spannung anlegbar ist, durch welche eine Zündung der Gasentladungsstrecken einleitbar ist. Bei einer derartigen Anordnung liegen sämtliche nicht angesteuerten zweiten Elektroden auf dem gleichen Potential, d.h. es entsteht eine Art Potentialschirm, der die unerwünschte Zündung von Gasentladungen in nicht ausgewählten Gasentladungskanälen verhindert.

Dabei ist es dann zweckmäßig, wenn mit Ausnahme der zu den zweiten Elektroden ausgewählter Gasentladungskanäle führenden zweiten Elektroden-Sammelleitungen sämtliche zweiten Elektroden-Sammelleitungen miteinander verbindbar sind. Durch diese Maßnahme ist die Bildung eines Potentialschirms durch die zweiten Elektroden auch dann gewährleistet, wenn sich nicht sämtliche Elektroden-Sammelleitungen kreuzen. Insbesondere können dann die Abmessungen der Trägerplatte auf die Abmessungen einer zu prüfenden Leiterplatte genau abgestimmt werden. Zur weiteren Steigerung der Funktionssicherheit können dann auch zusätzlich noch die miteinander verbundenen zweiten Elektroden-Sammelleitungen an ein Potential angeschlossen werden, welches eine Zündung der Gasentladungsstrekken verhindert.

Schließlich können auch noch sämtliche Gasentladungskanäle mit einer ionisierenden Strahlung beaufschlagt werden. Durch eine derarige Beaufschlagung mit einer ionisierenden Strahlung, beispielsweise mit einer UV-Strahlung, werden Zündverzögerungen vermieden, d.h. die Sicherheit und die Geschwindigkeit einer elektrischen Funktionsprüfung können weiter gesteigert werden.

Ausführungsbeispiele der Erfindung sind in der Zeichnung dargestellt und werden im folgenden näher beschrieben.

Es zeigen

Figur 1 das Prinzip einer erfindungsgemäßen Vorrichtung für die elektrische Funktionsprüfung von Leiterplatten,

Figur 2 eine Variante des in Figur 1 gezeigten Prinzips,

Figur 3 die Ausgestaltung einer Trägerplatte mit Gasentladungskanälen, Elektroden und Elektroden-Sammelleitungen,

Figur 4 das Prinzip der Matrixadressierung ausgewählter Meßstellen bei der in Figur 3 dargestellten Trägerplatte,

Figur 5 das Prinzip der Matrixadressierung bei einer gegenüber der Darstellung in Figur 4 um einen Winkel von 90° verdrehten Anordnung der Trägerplatte,

Figur 6 eine erste Variante der Anordnung der Elektroden der Gasentladungskanäle und die

Figuren 7 bis 10 verschiedene Verfahrensstadien für die Anordnung der Elektroden der Gasentladungskanäle gemäß einer zweiten Variante.

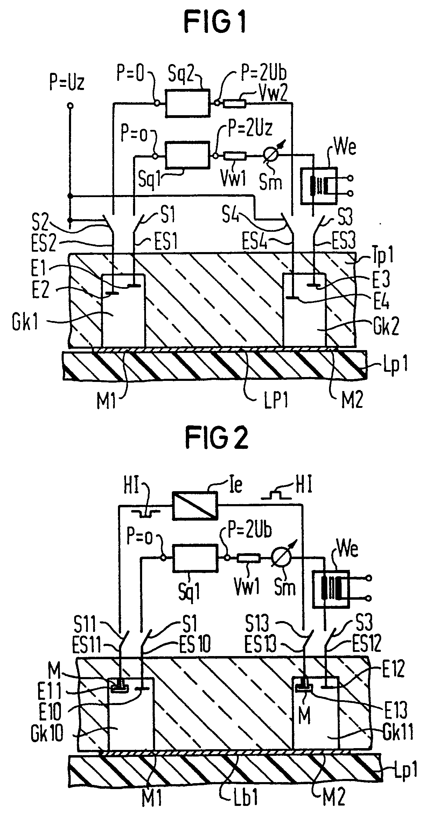

Figur 1 zeigt in stark vereinfachter schematischer Darstellung die Wirkungsweise einer Vorrichtung für die elektrische Funktionsprüfung von Leiterplatten auf der Basis einer berührungslosen ionischen Kontaktierung der Meßstellen über Gasentladungsstrecken. Es ist ein Teil einer mit Lpl bezeichneten Leiterplatte zu erkennen, auf deren Oberseite die Enden einer Leiterbahn Lb1 Meßstellen M1 und M2 bilden. Auf die Oberseite der Leiterplatte Lp1 ist eine Trägerplatte Tp1 aus einem isolierenden Material wie z.B. Glas aufgesetzt, in welche in Form von Sacklöchern eine Vielzahl von Gasentladungskanälen eingebracht ist. In der Zeichnung sind dabei nur der der Meßstelle M1 zugeordnete Gasentladungskanal Gk1 und der der Meßstelle M2 zugeordnete Gasentladungskanal Gk2 dargestellt. Auf der der Meßstelle M1 gegenüberliegenden Seite des Gasentladungskanals Gk1 sind Elektroden E1 und E2 angeordnet, wobei die Elektrode E2 etwas tiefer liegt als die Elektrode E1. Dabei sind die Elektrode E1 an eine Elektroden-Sammelleitung ES1 und die Elektrode E2 an eine Elektroden-Sammelleitung ES2 angeschlossen. In entsprechender Weise sind auf der der Meßstelle M2 gegenüberliegenden Seite des Gasentladungskanals Gk2 Elektroden E3 und E4 angeordnet, wobei die Elektrode E4 wieder etwas tiefer, d.h. auf gleicher Höhe mit der Elektrode E2 liegt. Die Elektrode E3 ist an eine Elektroden-Sammelleitung ES3 angeschlossen, während die Elektrode E4 an eine Elektroden-Sammelleitung ES4 angeschlossen ist. Über die Elektroden-Sammelleitungen ES1, ES2, ES3 und ES4 sind dabei jeweils die Elektroden einer Vielzahl von in Figur 1 nicht dargestellten Gasentladungskanälen reihenweise miteinander verbunden.

Werden nun bei der elektrischen Funktionsprüfung der Leiterplatte Lp1 die beiden Meßstellen M1 und M2 ausgewählt, so werden die ersten Elektroden E1 und E3 der zugeordneten Gasentladungskanäle Gk1 und Gk2 über die ersten Elektroden-Sammelleitungen ES1 und ES3 angesteuert, wobei diese Ansteuerung durch Schalter S1 und S3 aufgezeigt ist. Zwischen den Schaltern S1 und S3 sind nacheinander in Reihe eine Spannungsquelle Sq1, ein Vorwiderstand Vw1, ein Strommeßgerät Sm und ein Wechselspannungserzeuger We angeordnet.

Die vorstehend beschriebene Ansteuerung der ersten Elektroden E1 und E3 reicht für eine eindeutige Auswahl der Meßstellen M1 und M2 noch nicht aus. Um diese eindeutige Auswahl zu gewährleisten, werden nach dem Koinzidenzprinzip gleichzeitig die zweiten Elektroden E2 und E4 der zugeordneten Gasentladungskanäle Gk1 und Gk2 über die Elektroden-Sammelleitungen ES2 und ES4 angesteuert, wobei diese Ansteuerung durch Schalter S2 und S4 aufgezeigt ist. Im nicht angesteuerten Zustand der zweiten Elektroden E2 und E4 sind diese zweiten Elektroden E2 und E4 bei der dargestellten Stellung der Schalter S2 und S4 miteinander verbunden und an ein Potential P = Uz angeschlossen. An dieses Potential P sind im übrigen alle diejenigen zweiten Elektroden angeschlossen, die nicht über zugeordnete zweite Elektroden-Sammelleitungen angeschlossen sind. In der anderen, nicht dargestellten Stellung sind zwischen den Schaltern S2 und S4 nacheinander in Reihe eine Spannungsquelle Sq2 und ein Vorwiderstand Vw2 angeordnet.

Die gesamte in Figur 1 dargestellte Anordnung befindet sich in einem evakuierbaren Raum unter einem verminderten Druck von beispielsweise $13,3.10^{-3}$ bar (10 Torr), wobei der evakuierbare Raum mit einem Gas wie z.B. Stickstoff gefüllt ist. Somit sind zwischen der ersten Elektrode E1 und der Meßstelle M1 sowie zwischen der ersten Elektrode E3 und der Meßstelle M2 Gasentladungsstrecken gebildet, die über die Leiterbahn Lb1 in Reihe geschaltet sind. Die Spannung der Spannungsquelle Sq1 ist nun derart bemessen, daß an diese beiden in Reihe geschalteten Gasentladungsstrecken über die Schalter S1 und S3 zumindest die doppelte Zündspannung Uz einer Gasentladungsstrecke angelegt ist. Dabei ist der ersten Elektrode E1 das Potential P = o zugeordnet, während der ersten Elektrode E3 das Potential P = 2 Uz der Spannungsquelle Sq1 zugeordnet ist. Obwohl an den ersten Elektroden E1 und E3 die doppelte Zündspannung Uz anliegt, kommt es dadurch allein noch zu keiner Zündung der in Reihe geschalteten Gasentladungsstrecken. Eine derartige Zündung wird durch die zweiten Elektroden E2 und E4 verhindert, die im nicht angesteuerten Zustand einen Potentialschirm bilden und im dargestellten Ausführungsbeispiel auf dem Potential P = Uz liegen. Erst im angesteuerten Zustand liegen die Elektroden E2 und E4 auf einem Potential, bei welchem eine Zündung der Gasentladungsstrecken über die ersten Elektroden E1 und E3 erfolgen kann. Bei der Ansteuerung über die Schalter S2 und S4 wird an die zweiten Elektroden E2 und E4 eine Spannung angelegt, welche beispielsweise der doppelten Brennspannung Ub einer Gasentladungsstrecke entspricht. Dabei ist der zweiten Elektrode E2 das Potential P = o zugeordnet, während der zweiten Elektrode E4 das Potential P = 2 Ub der Spannungsquelle Sq2 zugeordnet ist.

Werden die erste Elektrode E1 über die erste Elektroden-Sammelleitung ES1, die zweite Elektrode E2 über die zweite Elektroden-Sammelleitung ES2, die erste Elektrode E3 über die erste Elektroden-Sammelleitung ES3 und die zweite Elektrode E4 über die zweite Elektroden-Sammelleitung ES4 nach dem Koinzidenzprinzip angesteuert, so werden in den ausgewählten Gasentladungskanälen Gk1 und Gk2 Gasentladungen gezündet, sofern die beiden Meßstellen M1 und M2 elektrisch hinreichend leitend miteinander verbunden sind. Die einmal gezündeten Gasentladungen können dann über die zweiten als Gitter wirkenden Elektroden E2 und E4 nicht mehr beeinflußt werden. Das Brennen der beiden Gasentladungen kann dabei über das in den Stromkreis eingeschaltete Strommeßgerät Sm registriert werden. Unterbleibt die Zündung oder fließt nach einer Zündung ein zu geringer Strom, so kann auf eine Unterbrechung der Leiterbahn Lb1 oder auf eine von vorneherein nicht existierende elektrisch leitende Verbindung zwischen den Meßstellen M1 und M2 geschlossen werden. Für Messungen des Widerstandes zwischen den Meßstellen M1 und M2 wird über den Wechselspannungserzeuger We zusätzlich eine Wechselspannung überlagert, wobei diese Überlagerung wie im dargestellten Ausführungsbeispiel durch induktive Ankoppelung vorgenommen werden kann. Die Widerstandsmessungen werden am differentiellen Umkehrpunkt der Gasentladungscharakteristik vorgenommen, wobei die Innenwiderstände der Gasentladungsstrecken praktisch wechselstrommäßig überbrückt werden. Dabei führen kleine Schwankungen $\triangle U$ der überlagerten Wechselspannung zu relativ großen Schwankungen $\triangle I$ des Stromes. Das im Stromkreis angeordnete phasenempfindliche Strommeßgerät Sm, bei welchem es sich beispielsweise um einen handelsüblichen lock-in-amplifier handeln kann, registriert die Stromschwankungen $\triangle I$ und der Widerstand R kann aus der Beziehung $R = \triangle U/\triangle I$ ermittelt werden. Aus der Höhe des ermittelten Widerstandes R kann dann ggf. auf Fehler geschlossen werden, bei welchen die Leiterbahn Lb1 nur teilweise unterbrochen ist. Außerdem kann die Ermittlung des Widerstandes R auch für Isolationsmessungen herangezogen werden.

Figur 2 zeigt eine Variante, bei welcher die Trägerplatte mit Tp10 und die den Meßstellen M1 und M2 zugeordneten Gasentladungskanäle mit Gk10 und Gk11 bezeichnet sind. Die Ansteuerung der ersten Elektroden E10 und E12 erfolgt in der zuvor beschriebenen Weise über die Schalter S1 und S3 und entsprechende erste Elektroden-Sammelleitungen ES10 bzw. ES12. Die Spannungsquelle Sq1 ist dabei jedoch auf eine Spannung eingestellt, welche zumindest der doppelten Brennspannung Ub einer Gasentladungsstrecke entspricht, die doppelte Zündspannung Uz aber nicht erreicht. Im dargestellten Ausführungsbeispiel ist der ersten Elektrode E1 das Potential P = o zugeordnet, während der ersten Elektrode E12 das Potential P = 2 Ub zugeordnet ist.

Die zweiten mit E11 und E13 bezeichneten Elektroden der Gasentladungskanäle Gk10 bzw. Gk11 werden über zugeordnete Elektroden-Sammelleitungen ES10 bzw. ES13 und Schalter S11 bzw. S13 angesteuert. Im angesteuerten Zustand sind die beiden zweiten Elektroden E11 und E13 an einen Impulserzeuger Ie angeschlossen, über welchen zur Zündung von Gasentladungen gleichzeitig eine Beaufschlagung mit Hochspannungs-Impulsen HI entgegengesetzter Polarität vorgenommen werden kann. Im dargestellten Fall wird die zweite Elektrode E11 mit einem negativen Hochspannungs-Impuls HI beaufschlagt, während die zweite Elektrode E13 gleichzeitig mit einem positiven Hochspannungs-Impuls HI beaufschlagt wird. Die Hochspannungs-Impulse HI, die deutlich größer sind als die Zündspannung Uz, können eine sichere Zündung der Gasentladungen auch dann bewirken, wenn die zweiten Elektroden E11 und E13 mit einem elektrisch isolierenden Material M, wie z.B. einer Keramik, umhüllt sind. Andererseits hat die Umhüllung mit dem elektrisch isolierenden Material M den Vorteil, daß die zweiten Elektroden E11 und E13 als reine Zündelektroden wirken und die Gasentladungen sonst nicht beeinflussen.

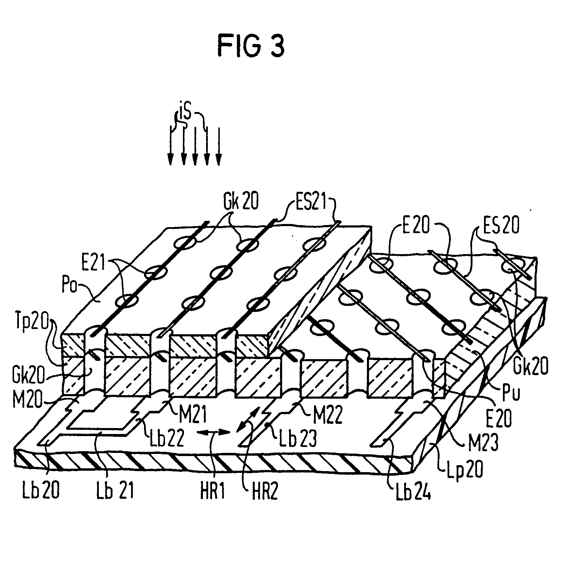

Figur 3 zeigt in perspektivischer Darstellung einen Teil einer Leiterplatte Lp20, auf deren Oberfläche im Rastermaß angeordnete Meßstellen M20, M21, M22 und M23 sowie Leiterbahnen Lb20, Lb21, Lb22, Lb23 und Lb24 zu erkennen sind. Die zueinander senkrechten Hauptrichtungen der Leiterbahnen sind mit HR1 und HR2 bezeichnet. Auf die Oberseite der Leiterplatte Lp20 ist eine insgesamt mit Tp20 bezeichnete Trägerplatte aufgesetzt, in welche eine Vielzahl zylindrischer Gasentladungskanäle Gk20 eingebracht ist. Die aus einer oberen Platte Po und einer unteren Platte Pu zusammengesetzte Trägerplatte Tp20 besteht aus fotolithografisch strukturierbarem Formglas, in welches die Gasentladungskanäle Gk20 mittels üblicher Maskierungs- und Ätztechniken eingebracht werden. In die Oberseite der oberen Platte Po sind ferner geradlinige und in der Hauptrichtung HR2 verlaufende Rillen eingebracht, in welchen erste Elektroden-Sammelleitungen ES21 verlaufen. Die mit E21 bezeichneten ersten Elektroden der Gasentladungskanäle Gk20 sind unmittelbar durch die Gasentladungskanäle Gk20 überquerende Abschnitte der Elektroden-Sammelleitungen ES21 gebildet. In die Unterseite der oberen Platte Po oder in die Oberseite der unteren Platte Pu sind geradlinige und zu den beiden Hauptrichtungen unter einem Winkel von 45° verlaufende Rillen eingebracht, in welchen zweite Elektroden-Sammelleitungen ES20 verlaufen. Die mit E20 bezeichneten zweiten Elektroden der Gasentladungskanäle Gk20 sind unmittelbar durch die Gasentladungskanäle Gk20 überquerende Abschnitte der zweiten Elektroden-Sammelleitungen ES20 gebildet. Die Herstellung der bandförmigen Elektroden-Sammelleitungen ES20 und ES21 mit den zugehörigen Elektroden E20 bzw. E21 kann mit auf dem Gebiet der gedruckten Schaltungen oder Schichtschaltungen üblichen Techniken vorgenommen werden, wobei als Materialien Edelmetalle wie z.B. Gold geeignet sind.

Die Lage der Gasentladungskanäle Gk20 entspricht genau dem Raster der Meßstellen einer zu prüfenden Leiterplatte Lp20, wobei in Figur 3 die genaue Zuordnung von in der Schnittebene der Trägerplatte Tp20 liegenden Gasentladungskanälen Gk20 zu den unmittelbar darunter liegenden Meßstellen M20, M21, M22 und M23 deutlich zu erkennen ist. Es ist ferner zu erkennen, daß die Anzahl der in Zeilen und Spalten angeordneten Gasentladungskanäle Gk20 durchaus größer sein kann als die Anzahl der auf der Leiterplatte Lp20 vorhandenen Meßstellen.

Die Stärke der oberen Platte Po ist in Figur 3 stark übertrieben. In Wirklichkeit ist die Stärke der oberen Platte Po sehr gering im Verhältnis zur Stärke der unteren Platte Pu, so daß auch der Abstand zwischen der ersten Elektrode E21 und der zweiten Elektrode E20 eines Gasentladungskanals Gk20 klein ist im Verhältnis zum Abstand zwischen der zweiten Elektrode E20 und einer zugeordneten Meßstelle. Durch diese Bemessung werden unerwünschte Gasentladungen zwischen einer ersten Elektrode E21 und einer zweiten Elektrode E20 sicher verhindert. Um Gasentladungen zwischen benachbarten ersten Elektroden E21 bzw. ersten Elektroden-Sammelleitungen ES21 zu verhindern, wird auf die Oberseite der oberen Platte Po zusätzlich noch eine in Figur 3 nicht dargestellte Deckplatte aus isolierendem Material aufgesetzt. Im dargestellten Fall besteht diese Deckplatte aus Glas, so daß sämtliche Gasentladungskanäle Gk20 mit einer durch Pfeile nur angedeuteten ionisierenden Strahlung iS beaufschlagt werden können. Durch diese ionisierende Strahlung iS, bei der es sich beispielsweise um eine UV-Strahlung handelt, werden Zündverzögerungen vermieden und die Sicherheit und Geschwindigkeit der elektrischen Funktionsprüfung gesteigert.

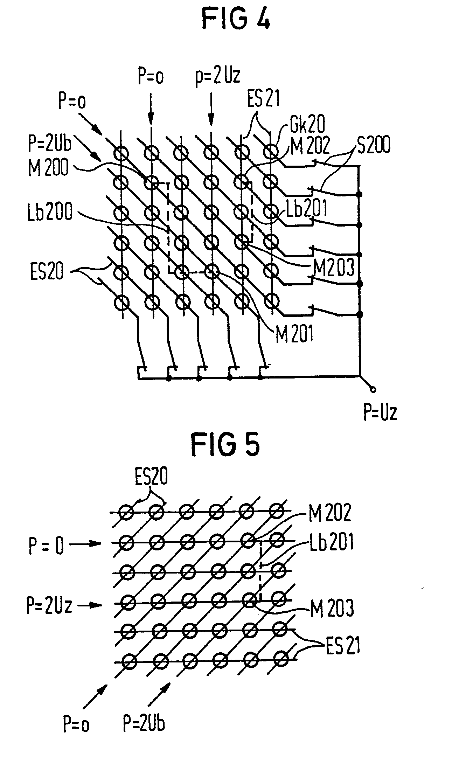

Figur 4 zeigt das Prinzip der Matrixadressierung ausgewählter Meßstellen der in Figur 3 dargestellten Vorrichtung in stark vereinfachter schematischer Darstellung. In der Draufsicht sind 6x6 Gasentladungskanäle Gk20 zu erkennen, die von den zugeordneten Elektroden-Sammelleitungen ES20 und ES21 durchzogen sind. Ferner liegen unter zwei der Gasentladungskanäle Gk20 mit M200 und M201 bezeichnete Meßstellen, die durch eine gestrichelt dargestellte Leiterbahn Lb200 verbunden sein sollten. Um diese Leiterbahn Lb200 zu überprüfen, werden die Meßstellen M200 und M201 in der in Figur 1 beschriebenen Weise angesteuert. Bei dieser in Figur 4 lediglich durch Pfeile angedeuteten Ansteuerung wird die der Meßstelle M200 zugeordnete erste Elektroden-Sammelleitung ES21 an das Potential P = o gelegt, während die der Meßstelle M201 zugeordnete erste Elektroden-Sammelleitung ES21 an das Potential P = 2 Uz gelegt wird. Weiterhin wird die der Meßstelle M200 zugeordnete zweite Elektroden-Sammelleitung ES20 an das Potential P = o gelegt, während die der Meßstelle M201 zugeordnete zweite Elektroden-Sammelleitung ES20 an das Potential P = 2 Ub gelegt wird. Alle anderen zweiten Elektroden-Sammelleitungen ES20 sind über Schalter S200 an ein Potential P = Uz oder ein anderes festes Potential unterhalb Uz gelegt. Mit dieser Matrixadressierung sind nur in denjenigen Gasentladungskanälen Gk20, die den Meßstellen M200 und M201 zugeordnet sind, die Voraussetzungen für ein Zünden und Brennen von Gasentladungen gegeben.

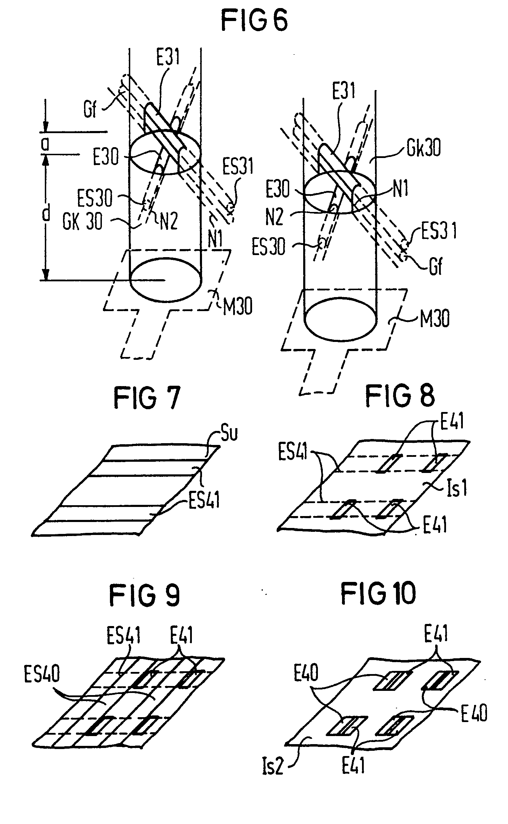

Die vorstehend anhand der Figur 4 beschriebene Matrixadressierung versagt nur dann, wenn den ausgewählten Meßstellen bzw. Gasentladungskanälen Gk20 die gleiche erste Elektroden-Sammelleitung ES21 oder die gleiche zweite Elektroden-Sammelleitung ES20 zugeordnet ist. Dieser Fall ist in Figur 4 durch Meßstellen M202 und M203 aufgezeigt, die durch eine gestrichelt dargestellte Leiterbahn Lb201 miteinander verbunden sein sollen und denen die gleiche erste Elektroden-Sammelleitung ES21 zugeordnet ist. Die Matrixadressierung dieser Meßstellen M202 und M203 bzw. die Prüfung der Leiterbahn Lb201 geht aus Figur 5 hervor.

Gemäß Figur 5 haben die auf der Leiterplatte Lp20 (vgl. Figur 3) liegenden Meßstellen M202 und M203 sowie die Leiterbahn Lb201 wieder die gleiche Lage, wie sie in Figur 4 dargestellt ist. Die Trägerplatte Tp20 (vgl. Figur 3) wurde jedoch gegenüber der in Figur 4 dargestellten Anordnung um einen Winkel von 90° im Uhrzeigersinn gedreht. Es ist ersichtlich, daß aufgrund dieser Drehung und dem entsprechend geänderten Verlauf der ersten Elektroden-Sammelleitungen ES21 und der zweiten Elektroden-Sammelleitungen ES20 eine Matrixadressierung der Meßstellen M202 und M203 ohne weiteres möglich ist, so wie es wiederum durch entsprechende Pfeile aufgezeigt ist. Anstelle der Verdrehung einer Vorrichtung kann für die Erfassung sämtlicher Meßstellen auch eine von vorneherein entsprechend ausgebildete zweite Vorrichtung verwendet werden.

Figur 6 zeigt in stark vereinfachter schematischer Darstellung eine erste Variante der Anordnung der ersten und zweiten Elektroden der Gasentladungskanäle. Von den in eine aus zwei Schichten zusammengesetzte Trägerplatte eingebrachten Gasentladungskanälen Gk30 ist dabei lediglich die Kontur zu erkennen. Die ersten Elektroden-Sammelleitungen ES31, welche die ersten Elektroden E31 bilden, verlaufen in einer Nut N1. Die zweiten Elektroden-Sammelleitungen ES30, welche die zweiten Elektroden E30 bilden, verlaufen in einer Nut N2. Der Abstand a zwischen den ersten Elektroden-Sammelleitungen ES30 und den zweiten Elektroden-Sammelleitungen ES31, die sich unter einem Winkel von 45° kreuzen, ist durch elektrisch isolierende Glasfasern Gf definiert, die ebenfalls in den Nuten N1 verlegt sind. Auf diese Weise können die ersten Elektroden E31 und die zweiten Elektroden E30 ohne sich zu berühren dicht aneinandergerückt werden. Das Verhältnis des Abstandes a zwischen einer ersten Elektrode E31 und einer zweiten Elektrode E30 zum Abstand d zwischen einer zweiten Elektrode E30 und einer zugeordneten Meßstelle M30 ist dabei so klein, daß zwischen den ersten Elektroden E31 und den zweiten Elektroden E30 keine Gasentladungen zünden können. Dies ist mit Sicherheit gewährleistet, wenn daß Verhältnis a : d mindestens 1 : 10 beträgt.

Die Figuren 7 bis 10 zeigen verschiedene Verfahrensstadien für die Anordnung der ersten und zweiten Elektroden gemäß einer zweiten Variante. Gemäß Figur 7 werden auf ein Substrat Su aus Glas zunächst Leiterbahnen in Dickschichttechnik aufgebracht, wobei diese Leiterbahnen parallel verlaufende erste Elektroden-Sammelleitungen ES41 bilden. Gemäß Figur 8 wird dann ganzflächig eine erste Isolierschicht Is1 aufgebracht, welche lediglich in Form von Fenstern diejenigen Bereiche der ersten Elektroden-Sammelleitungen ES41 nicht abdeckt, die erste Elektroden E41 bilden. Auf die erste Isolierschicht Is1 werden dann gemäß Figur 9 weitere Leiterbahnen in Dickschichttechnik aufgebracht, wobei diese Leiterbahnen parallel verlaufende und die ersten Elektroden-Sammelleitungen ES41 unter einem Winkel von 45° kreuzende zweite Elektroden-Sammelleitungen ES40 bilden. Schließlich wird dann wieder ganzflächig eine zweite Isolierschicht Is2 aufgebracht, welche lediglich in Form von Fenstern die ersten Elektroden E41 und diejenigen Bereiche der zweiten Elektroden-Sammelleitungen ES40 nicht abdeckt, die zweite Elektroden E40 bilden. Wie Figur 10 zeigt, liegen dann nur noch die ersten Elektroden E41 und die zweiten Elektroden E40 frei, während die gesamte übrige Fläche durch die zweite Isolierschicht Is2 abgedeckt wird. Das derart bedruckte Substrat Su braucht dann nur noch mit der Oberseite nach unten auf eine Trägerplatte aufgesetzt zu werden, in welche in einem entsprechenden Raster Gasentladungskanäle als Durchgangslöcher eingebracht sind. Am oberen Ende eines jeden Gasentladungskanals befinden sich dann jeweils dicht nebeneinander und gegeneinander elektrisch isoliert eine erste Elektrode E41 und eine zweite Elektrode E40.

Bei dem anhand der Figur 3 beschriebenen Ausführungsbeispiel beträgt das Rastermaß der Meßstellen und damit auch der Gasentladungskanäle Gk20 beispielsweise 1/40″, d.h. etwa 0,6 mm. Der Durchmesser der Gasentladungskanäle Gk20 beträgt dann 0,3 mm und der etwa der Stärke der gesamten Trägerplatte Tp20 entsprechende Abstand e zwischen den ersten Elektroden E21 und den zugeordneten Meßstellen 0,5 mm. Die gesamte Anordnung befindet sich bei einem reduzierten Druck p von etwa $13,3.10^{-3}$ bar (10 Torr) in einer Stickstoffatmosphäre. Bei dem Produkt $p.e = 6,5.10^{-3}$ bar.mm (5 Torr.mm) liegt bei Stickstoff das Minimum der Zündspannung Uz, das etwa 350 Volt beträgt. An die zu ausgewählten Meßstellen bzw. Gasentladungskanälen Gk20 führenden ersten Elektroden-Sammelleitungen ES21 wird dann die doppelte Zündspannung mit $2 Uz = 700$ Volt angelegt. An die zu diesen ausgewählten Meßstellen bzw. Gasentladungskanälen Gk20 führenden zweiten Elektroden-Sammelleitungen ES20 wird eine Spannung angelegt, welche mindestens der doppelten Brennspannung entspricht und beispielsweise 650 Volt beträgt.

Soll mit der anhand der Figuren 3 bis 5 beschriebenen Vorrichtung eine Leiterplatte Lp20 mit $Z = n \times n$ im Raster angeordneten Meßstellen geprüft werden, so werden n erste Elektroden-Sammelleitungen ES21 und (2n-1) zweite Elektroden-Sammelleitungen ES20 benötigt. Bei einer Anzahl von z Meßstellen beträgt die Gesamtanzahl der Elektroden-Sammelleitungen also

$$Z = \sqrt{3 z - 1}$$

Dies bedeutet, daß bei $z = 10\,000$ Meßstellen nicht mehr 10 000 Zuleitungen sondern nur noch $Z = 299$ Elektroden-Sammelleitungen benötigt werden.

**Patentansprüche**

1. Vorrichtung für die elektrische Funktionsprüfung von Verdrahtungsfeldern, insbesondere von Leiterplatten (Lp1; Lp20), mit einer auf die Verdrahtungsfelder aufsetzbaren Trägerplatte (Tp1; Tp20), in welche eine Vielzahl von mit Elektroden (E1, E3; E10, E12; E21; E31; E41) versehenen Gasentladungskanälen (Gk1, Gk2; Gk10, Gk11; Gk20, Gk30) eingebracht ist, wobei jeweils mindestens zwei ausgewählte Meßstellen (M1, M2; M20, M21, M22; M200, M201, M202, M203) eines Verdrahtungsfeldes über die zugeordneten Gasentladungskanäle (Gk1, Gk2; Gk10, Gk11; Gk20, Gk30) und deren Elektroden (E1, E3; E10, E12; E21; E31; E41) ionisch kontaktierbar sind, dadurch gekennzeichnet, daß jeder Gasentladungskanal (Gk1, Gk2; Gk10, Gk11; Gk20; Gk30) mit ersten Elektroden (E1, E3; E10, E12; E21; E31; E41) und mit zweiten Elektroden (E2, E4; E11, E13; E20; E30; E40) ausgerüstet ist,

daß jeweils die ersten Elektroden (E1, E3; E10, E12; E21; E31; E41) mehrerer Gasentladungskanäle (Gk1; Gk2; Gk10, Gk11; Gk20, Gk30) über eine zugeordnete erste Elektroden-Sammelleitung (ES1, ES3; ES10, ES12; ES21; ES31; ES41) miteinander verbunden sind, daß jeweils die zweiten Elektroden (E2, E4; E11, E13; E20; E30; E40) mehrerer Gasentladungskanäle (Gk1, Gk2; Gk10, Gk11; Gk20, Gk30) über eine zugeordnete zweite Elektroden-Sammelleitung (ES2, ES4; ES11, ES13, ES20; ES30; ES40) miteinander verbunden sind und

daß jeder Gasentladungskanal (Gk1, Gk2; Gk10, Gk11; Gk20; Gk30) nach dem Koinzidenzprinzip über eine zugeordnete erste Elektroden-Sammelleitung (ES1, ES3; ES10, ES12; ES21; ES31; ES41) und eine zugeordnete zweite Elektroden-Sammelleitung (ES2, ES4; ES11, ES13; ES20; ES30; ES40) auswählbar ist.

2. Vorrichtung nach Anspruch 1, dadurch gekennzeichnet, daß die ersten Elektroden (E1, E3; E10, E12; E21; E31; E41) der Gasentladungskanäle (Gk1, G2; Gk10, Gk11; Gk20; Gk30) reihenweise über die ersten Elektroden-Sammelleitungen (ES1, ES3; ES10, ES12; ES21; ES31; ES41) miteinander verbunden sind und daß die zweiten Elektroden (E2, E4; E11, E13; E20; E30; E40) der Gasentladungskanäle reihenweise über die zweiten Elektroden-Sammelleitungen (ES2, ES4; ES11, ES13; ES20; ES30; ES40) miteinander verbunden sind.

3. Vorrichtung nach Anspruch 2, dadurch gekennzeichnet, daß die ersten Elektroden (E1, E3; E21; E41) und die zweiten Elektroden (E2, E4; E20; E30; E40) in verschiedenen Höhenlagen der Gasentladungskanäle (Gk1, Gk2; Gk20; Gk30) angeordnet sind.

4. Vorrichtung nach Anspruch 2 oder 3, dadurch gekennzeichnet, daß die zweiten Elektroden (E11, E13) mit einem elektrisch isolierenden Material (M) umhüllt sind.

5. Vorrichtung nach einem der vorhergehenden Ansprüche, dadurch gekennzeichnet, daß die Elektroden (E20, E21; E30, E31; E40, E41) durch die Gasentladungskanäle (Gk20; Gk30) überquerende Abschnitte der Elektroden-Sammelleitungen (ES20, ES21; ES30, ES31; ES40, ES41) gebildet sind.

6. Vorrichtung nach einem der Ansprüche 2 bis 5, dadurch gekennzeichnet, daß die ersten Elektroden-Sammelleitungen (ES21; ES31; ES41) und die zweiten Elektroden-Sammelleitungen (ES20; ES30; ES40) sich kreuzend angeordnet sind.

7. Vorrichtung nach Anspruch 6, dadurch gekennzeichnet, daß die ersten Elektroden-Sammelleitungen (ES21; ES31; ES41) und die zweiten Elektroden-Sammelleitungen (ES20; ES30; ES40) sich unter einem Winkel von 45° kreuzen.

8. Vorrichtung nach einem der Ansprüche 2 bis 7, dadurch gekennzeichnet, daß der Abstand (a) zwischen der ersten Elektrode (E31) und der zweiten Elektrode (E30) eines Gasentladungskanals (Gk30) klein ist im Verhältnis zum Abstand (d) zwischen der zweiten Elektrode (E30) und einer zugeordneten Meßstelle (M30).

9. Vorrichtung nach Anspruch 8, dadurch gekennzeichnet, daß das Verhältnis des Abstandes (a) zwischen der ersten Elektrode (E31) und der zweiten Elektrode (E30) zum Abstand (d) zwischen der zweiten Elektrode (E30) und der zugeordneten Meßstelle (M30) mindestens 1 : 10 beträgt.

10. Vorrichtung nach Anspruch 8 oder 9, dadurch gekennzeichnet, daß zwischen der ersten Elektrode (E31; E41) und der zweiten Elektrode (E30; E40) eines Gasentladungskanals (Gk30; Gk40) ein elektrischer Isolator angeordnet ist.

11. Vorrichtung nach einem der Ansprüche 5 bis 10, dadurch gekennzeichnet, daß die Elektroden-Sammelleitungen (ES20, ES21; ES40, ES41) bandförmig ausgebildet sind.

12. Vorrichtung nach Anspruch 11, dadurch gekennzeichnet, daß die Elektroden-Sammelleitungen (ES40, ES41) durch die Leiterbahnen einer Schichtschaltung gebildet sind.

13. Vorrichtung nach einem der Ansprüche 2 bis 12, dadurch gekennzeichnet, daß an die ersten Elektroden (E1, E3; E21) zweier ausgewählter Gasentladungskanäle (Gk1, Gk2; Gk20) über die zugeordneten ersten Elektroden-Sammelleitungen (ES1, ES3; ES21) eine Spannung anlegbar ist, welche zumindest der doppelten Zündspannung (Uz) einer Gasentladungsstrecke entspricht und daß an die zweiten Elektroden (E2, E4; E20) der beiden ausgewählten Gasentladungskanäle über die zugeordneten zweiten Elektroden-Sammelleitungen (ES2, ES4; ES20) eine derartige Spannung anlegbar ist, durch welche eine Zündung der Gasentladungsstrecken einleitbar ist.

14. Vorrichtung nach Anspruch 13, dadurch gekennzeichnet, daß mit Ausnahme der zu den zweiten Elektroden (E2, E4; E20) ausgewählter Gasentladungskanäle (Gk1, Gk2; Gk20) führenden zweiten Elektroden-Sammelleitungen (ES2, ES4; ES20) sämtliche zweiten Elektroden-Sammelleitungen miteinander verbindbar sind.

15. Vorrichtung nach Anspruch 14, dadurch gekennzeichnet, daß miteinander verbundene zweite Elektroden-Sammelleitungen (ES2, ES4; E20) an ein Potential (P) anschließbar sind, welches eine Zündung der Gasentladungsstrecken verhindert.

16. Vorrichtung nach einem der vorhergehenden Ansprüche, dadurch gekennzeichnet, daß sämtliche Gasentladungskanäle (Gk20) mit einer ionisierenden Strahlung (iS) beaufschlagbar sind.

**Revendications**

1. Dispositif pour tester le fonctionnement électrique de panneaux de câblage, notamment de plaquettes à circuits imprimés (Lp1; Lp20) et comportant une plaque de support (Tp2; Tp20), qui peut être placée sur les panneaux de câblage, et dans laquelle sont ménagés une multiplicité de canaux de décharge dans un gaz (Gk1, Gk2; Gk10, Gk11; Gk20, Gk30) pourvus d'électrodes (E1, E3; E10, E12; E21; E31; E41), et dans lequel respectivement au moins deux points de mesure sélectionnés (M1, M2; M20, M21, M22; M200, M201, M202, M203) d'un panneau de câblage peuvent être réunis par une liaison ionique au moyen des canaux associés de décharge dans un gaz (Gk1, Gk2; Gk10, Gk11; Gk20, Gk30) et de leurs électrodes (E1, E3; E10, E12; E21; E31; E41), caractérisé par le fait

que chaque canal de décharge dans un gaz (Gk1, Gk2; Gk10, Gk11; Gk20, Gk30) est pourvu de premières électrodes (E1, E3; E10, E12; E21; E31; E41) et de secondes électrodes (E2, E4; E11, E13; E20; E30; E40),

que respectivement les premières électrodes (E1, E3; E10, E12; E21; E31; E41) de plusieurs canaux de décharge dans un gaz (Gk1; Gk2; Gk10, Gk11; Gk20, Gk30) sont reliées entre elles par l'intermédiaire d'un premier conducteur (ES1, ES3; ES10, ES12; ES21; ES31; ES41) de réunion des électrodes,

que respectivement les secondes électrodes (E2, E4; E11, E13; E20; E30; E40) de plusieurs canaux de décharge dans un gaz (Gk1, Gk2; Gk10, Gk11; Gk20, Gk30) sont reliées entre elles par l'intermédiaire d'un second conducteur associé (ES2, ES4; ES11, ES13, ES20; ES30; ES40), et

que chaque canal de décharge dans un gaz (Gk1, Gk2; Gk10, Gk11; Gk20; Gk30) peut être sélectionné selon le principe de coïncidence par l'intermédiaire d'un premier conducteur associé (ES1, ES3; ES10, ES12; ES21; ES31; ES41) de réunion des électrodes et par un second conducteur associé (ES2, ES4; ES11, ES13; ES20; ES30; ES40) de réunion des électrodes.

2. Dispositif suivant la revendication 1, caractérisé par le fait que les premières électrodes (E1, E3; E10, E12; E21; E31; E41) des canaux de décharge dans un gaz (Gk1, Gk2; Gk10, Gk11; Gk20; Gk30) sont reliées entre elles en série par l'intermédiaire des premiers conducteurs (ES1, ES3; ES10, ES12; ES21; ES31; ES41) de réunion des électrodes et que les secondes électrodes des canaux de décharge dans un gaz sont reliées entre elles en série par l'intermédiaire des seconds conducteurs de réunion des électrodes.

3. Dispositif suivant la revendication 2, caractérisé par le fait que les premières électrodes (E1, E3; E21; E41) et les secondes électrodes (E2, E4; E20; E40) sont disposées dans des positions en hauteur différentes dans les canaux de décharge dans un gaz (Gk1, Gk2; Gk20; Gk30).

4. Dispositif suivant la revendication 2 ou 3, caractérisé par le fait que les secondes électrodes (E11, E13) sont enveloppées par un matériau électriquement isolant (M).

5. Dispositif suivant l'une des revendications précédentes, caractérisé par le fait que les électrodes (E20; E21; E30, E31; E40, E41) sont formées par de sections, qui s'étendent au-dessus des canaux de décharge dans un gaz (GK20; Gk30), des conducteurs (ES20, ES21; ES30, ES31; ES40, ES41) de réunion des électrodes.

6. Dispositif suivant l'une des revendications 2 à 5, caractérisé par le fait que les premiers conducteurs (ES21; ES31; ES41) de réunion des électrodes et les seconds conducteurs (ES20; ES30; ES40) de réunion des électrodes sont disposés de manière à se croiser.

7. Dispositif suivant la revendication 6, caractérisé par le fait que les premiers conducteurs (ES21; ES31; ES41) de réunion des électrodes et les seconds conducteurs (ES20; ES30; ES40) de réunion des électrodes se croisent sous un angle à 45°.

8. Dispositif suivant l'une des revendications 2 à 7, caractérisé par le fait que la distance (a) entre la première électrode (E31) et la seconde électrode (E30) d'un canal de décharge dans un gaz (Gk30) est faible par rapport à la distance (b) entre la seconde électrode (E30) et un point de mesure associé (M30).

9. Dispositif suivant la revendication 8, caractérisé par le fait que le rapport de la distance (a) entre la première électrode (E31) et la seconde électrode (E30) à la distance (d) entre la seconde électrode (E30) et le point de mesure associé (M30) est égal au moins à 1:10.

10. Dispositif suivant la revendication 8 ou 9, caractérisé par le fait qu'un isolant électrique est disposé entre la première électrode (E31; E41) et la seconde électrode (E30; E40) d'un canal de décharge dans un gaz (Gk30; Gk40).

11. Dispositif suivant l'une des revendications 5 à 10, caractérisé par le fait que les conducteurs (S20, S21; S40, S41) de réunion des électrodes sont réalisés sous la forme de bandes.

12. Dispositif suivant la revendication 11, caractérisé par le fait que les conducteurs (ES40, ES41) de réunion des électrodes sont formés par les voies conductrices d'un circuit de couches empilées.

13. Dispositif suivant l'une des revendications 2 à 12, caractérisé par le fait qu'aux premières électrodes (E1; E3; E21) de deux canaux sélectionnés de décharge dans un gaz (Gk1, Gk2; Gk20) est appliquée, par l'intermédiaire des premiers conducteurs associés (ES1; ES3; ES21) de réunion des électrodes, une tension qui correspond au moins au double de la tension d'amorçage (Uz) d'une section de décharge dans un gaz et qu'aux secondes électrodes (E2, E4; E20) des deux canaux sélectionnés de décharge dans un gaz peut être appliquée, par l'intermédiaire des seconds conducteurs associés (ES2, ES4; ES20) de réunion des électrodes, une tension telle qu'elle permet de déclencher un amorçage des sections de décharge dans un gaz.

14. Dispositif suivant la revendication 13, caractérisé par le fait qu'à l'exception des seconds conducteurs (ES2, ES4; ES20) de réunion des électrodes, qui aboutissent aux deux électrodes (E2, E4; E20) de canaux sélectionnés de décharge dans un gaz (Gk1, Gk2; Gk20), tous les seconds conducteurs de réunion des électrodes peuvent être reliés entre eux.

15. Dispositif suivant la revendication 14, caractérisé par le fait que des seconds conducteurs de réunion des électrodes (ES2, ES4; E20), qui sont reliés entre eux, peuvent être raccordés à un potentiel (P), qui empêche un amorçage des sections de décharge dans un gaz.

16. Dispositif suivant l'une des revendications précédentes, caractérisé par le fait que tous les canaux de décharge dans un gaz (Gk20) peuvent être chargés avec un rayonnement ionisant (iS).

**Claims**

1. Device for testing the electrical functioning of wired arrays, especially of printed-circuit boards (Lp1; Lp20), having a carrier plate (Tp1; Tp20) which can be placed on the wired array and which contain a plurality of gas discharge channels (Gk1, Gk2; Gk10, Gk11; Gk20, Gk30) provided with electrodes (E1, E3; E10, E12; E21; E31; E41), ionic contact of in each case at least two selected measuring points (M1, M2; M20, M21, M22; M200, M201, M202, M203) of a wired array being possible via the assigned gas discharge channels (Gk1, Gk2; Gk10, Gk11; Gk20, Gk30) and their electrodes (E1, E3; E10, E12; E21; E31; E41), characterized in that each gas discharge channel (Gk1, Gk2; Gk10, Gk11; Gk20; Gk30) is equipped with first electrodes (E1, E3; E10, E12; E21; E31; E41) and with second electrodes (E2, E4; E11, E13; E20; E30; E40), in that in each case the first electrodes (E1, E3; E10, E12; E21; E31; E41) of a plurality of gas discharge channels (Gk1; Gk2; Gk10, Gk11; Gk20, Gk30) are connected to one another via an assigned first electrode bus line (ES1, ES3; ES10, ES12; ES21; ES31; ES41), in that in each case the second electrodes (E2, E4; E11, E13; E20; E30; E40) of a plurality of gas discharge channels (Gk1, Gk2; Gk10, Gk11; Gk20, Gk30) are connected to one another via an assigned second electrode bus line (ES2, ES4; ES11, ES13, ES20; ES30; ES40), and in that each gas discharge channel (Gk1, Gk2; Gk10, Gk11; Gk20; Gk30) can be selected according to the coincidence principle via an assigned first electrode bus line (ES1, ES3; ES10, ES12; ES21; ES31; ES41) and an assigned second electrode bus line (ES2, ES4; ES11, ES13; ES20; ES30; ES40).

2. Device according to Claim 1, characterized in that the first electrodes (E1, E3; E10, E12; E21; E31; E41) of the gas discharge channels (Gk1, Gk2; Gk10, Gk11; Gk20; Gk30) are connected to one another in series via the first electrode bus lines (ES1, ES3; ES10, ES12; ES21; ES31; ES41), and in that the second electrodes (E2, E4; E11, E13; E20; E30; E40) of the gas discharge channels are connected to one another in series via the second electrode bus lines (ES2, ES4; ES11, ES13; ES20; ES30; ES40).

3. Device according to Claim 2, characterized in that the first electrodes (E1, E3; E21; E41) and the second electrodes (E2, E4; E20; E30; E40) are arranged at different height levels of the gas discharge channels (Gk1, Gk2; Gk20; Gk30).

4. Device according to Claim 2 or 3, characterized in that the second electrodes (E11, E13) are sheathed by an electrically insulating material (M).

5. Device according to one of the preceding claims, characterized in that the electrodes (E20, E21; E30, E31; E40, E41) are formed by the sections of the electrode bus lines (ES20, ES21; ES30, ES31; ES40, ES41) crossing over the gas discharge channels (Gk20; Gk30).

6. Device according to one of Claims 2 to 5, characterized in that the first electrode bus lines (ES21; ES31; ES41) and the second electrode bus lines (ES20; ES30; ES40) are arranged so as to cross over one another.

7. Device according to Claim 6, characterized in that the first electrode bus lines (ES21; ES31; ES41) and the second electrode bus lines (ES20; ES30; ES40) cross one another at an angle of 45°.

8. Device according to one of Claims 2 to 7, characterized in that the distance (a) between the first electrode (E31) and the second electrode (E30) of a gas discharge channel (Gk30) is small in relation to the distance (d) between the second electrode (E30) and an assigned measuring point (M30).

9. Device according to Claim 8, characterized in that the ratio of the distance (a) between the first electrode (E31) and the second electrode (E30) to the distance (d) between the second electrode (E30) and the assigned measuring point (M30) is at least 1 : 10.

10. Device according to Claim 8 or 9, characterized in that an electrical insulator is arranged between the first electrode (E31; E41) and the second electrode (E30, E40) of a gas discharge channel (Gk30; Gk40).

11. Device according to one of Claims 5 to 10, characterized in that the electrode bus lines (ES20, ES21; ES40, ES41) are designed in the form of a strip.

12. Device according to Claim 11, characterized in that the electrode bus lines (ES40, ES41) are formed by the conductor tracks of a film circuit.

13. Device according to one of Claims 2 to 12, characterized in that a voltage can be applied to the first electrodes (E1, E3; E21) of two selected gas discharge channels (Gk1, Gk2; Gk20) via the assigned first electrode bus lines (ES1, ES3; ES21), which voltage corresponds to at least twice the ignition voltage (Uz) of a gas discharge path, and that such a voltage, with which an ignition of the gas discharge paths can be initiated, can be applied to the second electrodes (E2, E4; E20) of the two selected gas discharge channels via the assigned second electrode bus lines (ES2, ES4; ES20).

14. Device according to Claim 13, characterized in that, with the exception of the second electrode bus lines (ES2, ES4; ES20) leading to the second electrodes (E2, E4; E20) of selected gas discharge channels (Gk1, Gk2; Gk20), all of the second electrode bus lines can be connected to one another.

15. Device according to Claim 14, characterized in that second electrode bus lines (ES2, ES4; E20) connected to one another can be connected to a potential (P) which prevents an ignition of the gas discharge paths.

16. Device according to one of the preceding claims, characterized in that all the gas discharge channels (Gk20) can be subjected to an ionizing-radiation (iS).

## FIG 1

## FIG 2

# FIG 3

# FIG 4

P=o

p=2Uz

P=o

ES 21

Gk20

M 202

S 200

P=2Ub

M 200

Lb 200

Lb 201

M 203

ES 20

M 201

P=Uz

# FIG 5

ES20

M 202

P = 0

Lb 201

P = 2Uz

M 203

ES 21

P=o

P=2Ub

## FIG 6

## FIG 7

## FIG 8

## FIG 9

## FIG 10